# EUROPÄISCHE PATENTSCHRIFT

(11) **EP 0 371 379 B1**
(45) Veröffentlichungstag und Bekanntmachung des Hinweises auf die Patenterteilung: **08.09.1993**
(21) Anmeldenummer: 89121533.7
(22) Anmeldetag: 21.11.1989
(51) Int. Cl.: H01S 3/085, H01S 3/103, H01S 3/19

(54) **Elektrisch abstimmbarer Halbleiterlaser mit Stegwellenleiter**
Electrically tunable semiconductor laser with a ridge waveguide
Laser à semi-conducteur accordable électriquement avec guide d'ondes à moulures

(30) Priorität: 30.11.1988 DE 3840411
(43) Veröffentlichungstag der Anmeldung: 06.06.1990
(73) Patentinhaber: SIEMENS AKTIENGESELLSCHAFT, 80333 München (DE)
(72) Erfinder: Heinen, Jochen, Dr., D-8013 Haar (DE)

(56) Entgegenhaltungen:
- EP-A- 0 033 137
- EP-A- 0 296 066
- PATENT ABSTRACTS OF JAPAN, Band 10, Nr. 317 (E-449)(2373), 28. Oktober 1986; & JP-A-61 128 589
- JOURNAL OF OPTICAL COMMUNICATIONS, Band 6, Nr. 2, Juni 1985, Seiten 42-43, Fachverlag Schiele & Schon, Berlin, DE; G. MÜLLER et al.: "Fabrication and characteristics of MCRW GaAs/GaAlAs lasers on semiinsulating substrate"
- PATENT ABSTRACTS OF JAPAN, Band 13, Nr. 97 (E-723)(3445), 7. März 1989; & JP-A-63 272 088

## Beschreibung

Für verschiedene Anwendungen von Halbleiterlasern wie beispielsweise in der optischen Kommunikationstechnik beim Überlagerungsempfang oder Wellenlängenmultiplex werden Laser benötigt, deren Wellenlänge der emittierten Strahlung in einem gewissen Bereich abstimmbar ist. Es wird angestrebt, die Abstimmbarkeit nicht über langsame thermische Effekte, sondern mit schnellen elektrooptischen Effekten zu realisieren. Eine Möglichkeit der Wellenlängenabstimmung ist die durch Ladungsträger bedingte Verschiebung des Brechungsindex in einen Teil des lichtleitenden Halbleitermaterials.

Bisher existieren elektrisch abstimmbare Laser in Konfigurationen, bei denen optoelektronisch aktive streifenförmige Halbleiterbereiche in Richtung des geführten Lichts hintereinander angeordnet sind. Mindestens ein Bereich ist dabei als Halbleiterlaser ausgelegt. Der Brechungsindex in mindestens einem weiteren Bereich wird beispielsweise durch Injektion von Ladungsträgern in den lichtführenden Streifen geändert und ruft damit eine Änderung der emittierten Wellenlänge hervor. Laser und Abstimmbereich können im Prinzip statt hintereinander auch übereinander angeordnet sein. Es ist keine Anordnung bekannt, bei der dieses Prinzip der übereinander angeordneten Laser- und Abstimmzonen bei einer Laserstruktur mit Stegwellenleiter realisiert ist.

In der EP 0 173 269 A2 ist ein Halbleiterlaseraufbau beschrieben, bei dem in longitudinaler Anordnung ein aktiver Bereich zwischen einem ersten Kontrollbereich und einem zweiten Kontrollbereich, die jeweils mit Elektroden zur Ansteuerung versehen sind, vorhanden ist. Die Abstimmung dieses Halbleiterlasers erfolgt durch eine kontinuierliche Variation der diesen Abstimmelektroden zugeführten Stromstärken.

In N.K. Dutta et al.: "Continuously tunable distributed feedback laser diode", Appl. Phys. Lett. 47, 981 bis 983 (1985) ist ein abstimmbarer Halbleiterlaser beschrieben, bei dem das Substrat aus InP als thermoelektrisches Element fungiert, dessen Komponente durch einen oberen und einen unteren Kontakt auf dem Substrat gebildet werden. Eine Temperaturdifferenz zwischen diesen beiden Komponenten kann durch den Peltier-Effekt, wenn ein Strom an diese beiden Kontakte angelegt wird, erzeugt werden. Die Funktionsweise der Abstimmung bei diesem Aufbau besteht also in einer Kombination aus einer Widerstandsheizung und einer Peltier-Kühlung.

In der EP 0 297 654 A1 stand der Technik nach Artikel 54(3) EPÜ ist ein Halbleiterlaser beschrieben, dessen Schichtaufbau die Injektion von heißen, d.h. energiereichen Elektronen in die aktive Schicht ermöglicht. Damit erreicht man eine kürzere Wellenlänge des von diesem Laser emittierten Lichtes.

In der EP 0 296 066 A2 Stand der Technik nach Artikel 54(3) EPÜ ist ein Halbleiterlaser beschrieben, der über eine MQW-Schicht transversal zu der eigentlichen aktiven Schicht angeordnet verfügt. Über einen gesonderten Kontakt wird an diese MQW-Schicht im Betrieb des Lasers eine Sperrspannung angelegt, mit der das elektrische Feld in dieser MQW-Schicht kontrolliert und auf diese Weise die Wellenlänge verändert werden kann.

Aufgabe der vorliegenden Erfindung ist es, einen elektrisch abstimmbaren Halbleiterlaser mit Stegwellenleiter anzugeben.

Die vorliegende Aufgabe wird mit einem Halbleiterlaser mit den Merkmalen des Ansprüches 1 gelöst. Weitere Ausgestaltungen ergeben sich aus den Unteransprüchen.

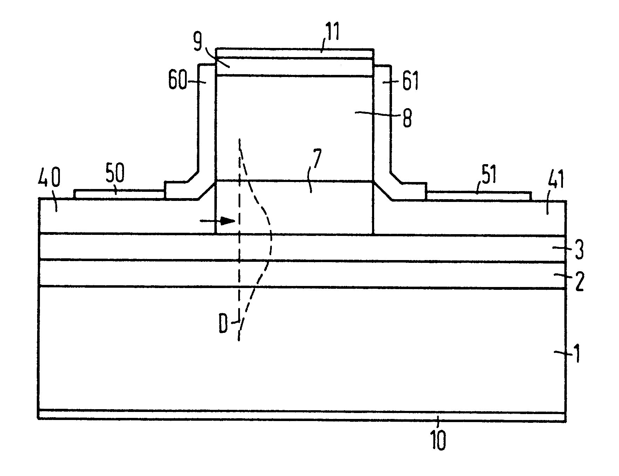

Es folgt eine Beschreibung eines erfindungsgemäßen Halbleiterlasers anhand der Figur. Der erfindungsgemäße abstimmbare Halbleiterlaser nutzt den Effekt aus, daß der Brechungsindex des Halbleitermaterials mit zunehmender Ladungsträgerdichte abnimmt, die Wellenlänge von teilweise in diesem Bereich geführten Licht sich damit vergrößert, sich also durch einen Injektionsstrom in Grenzen beeinflussen läßt.

Der erfindungsgemäße Aufbau ähnelt einem Stegwellenleiter mit MCRW-Struktur j.Opt. Commun., Bd.6, Nr.2, 1985, S.42-43. Auf das Substrat 1 aus n-leitend dotiertem InP ist die aktive Schicht 2 aus InGaAsP für die Wellenlänge 1,55 µm aufgewachsen. Darüber befindet sich eine p-leitend dotierte Zwischenschicht 3 aus InP. Darüber befindet sich eine streifenförmige Abstimmschicht 7 aus p-leitend dotiertem InGaAsP für die Wellenlänge 1,3 µm, über diese Abstimmschicht 7 eine ebenfalls streifenförmige Deckschicht 8 aus p-leitend dotiertem InP und darauf eine für niederohmigen Übergang hoch p-leitend dotierte Kontaktschicht 9 aus InGaAs. Seitlich an die Abstimmschicht 7 angrenzend sind auf die Zwischenschicht 3 eine erste Seitenbereichsschicht 40 und eine zweite Seitenbereichsschicht 41 aus jeweils n-leitend dotiertem InP aufgewachsen. Die Kontaktierung des Halbleiterlasers erfolgt über einen ganzflächig aufgebrachten Substratkontakt 10 auf der der überwachsenen Seite gegenüberliegenden Seite des Substrates 1, einen Stegkontakt 11 auf der Kontaktschicht 9 und einen ersten Abstimmkontakt 50 auf der ersten Seitenbereichsschicht 40 und einem zweiten Abstimmkontakt 51 auf der zweiten Seitenbereichsschicht 41. Die Oberfläche des Halbleitermaterials zwischen dem ersten Abstimmkontakt 50 und dem Stegkontakt 11 bzw. zwischen dem zweiten Abstimmkontakt 51 und dem Stegkontakt 11 sind jeweils mit einer ersten Passivierungsschicht 60 bzw. einer zweiten Passivierungsschicht 61 überdeckt.

Über die erste Seitenbereichsschicht 40 mit dem darauf befindlichen ersten Abstimmkontakt 50 und die zweite Seitenbereichsschicht 41 mit dem darauf befindlichen zweiten Abstimmkontakt 51 können von den Seiten her Ladungsträger in die Abstimmschicht 7 injiziert werden. Die Halbleiterschichten der ersten Seitenbereichsschicht 40 bzw. des zweiter Seitenbereichsschicht 41 sind in einem separaten Epitaxieprozeß aufgebracht. Der Laser wird wie üblich über den Stegkontakt 11 und den Substratkontakt 10 elektrisch versorgt bzw. moduliert. Der aus der Deckschicht 8 und der Kontaktschicht 9 bestehende Steg und die Seitenbereichsschichten 40, 41 bilden zusammen mit der streifenförmigen Abstimmschicht 7 eine weitere Halbleiterdiode.

In dem beschriebenen Ausführungsbeispiel sind das Substrat und die Seitenbereichsschichten 40, 41 n-leitend dotiert, die Zwischenschicht 3, die Abstimmschicht 7 und die Deckschicht 8 sind p-leitend, die Kontaktschicht 9 für niederohmigen Übergang vom Halbleitermaterial zum Metall des Kontaktes hinreichend hoch p-leitend dotiert. Bei Polung in Flußrichtung werden Ladungsträger (in diesem Ausführungsbeispiel Elektronen) in die Abstimmschicht 7 injiziert, wo sie - allseitig von Barrieren umgeben - nach einer gewissen Lebensdauer rekombinieren. Abhängig vom Volumen der Abstimmschicht 7, der Lebensdauer und der eingestellten Stromstärke stellt sich eine entsprechende Ladungsträgerdichte in der streifenförmigen Abstimmschicht 7 ein. Diese Dichte verändert den optischen Brechungsindex der Abstimmschicht 7. Da das Laserlicht zum Teil in diesem Bereich mit variablem Brechungsindex geführt wird, wie in der Figur durch das Diagramm D dargestellt, läßt sich also über die an dem ersten Abstimmkontakt 50 und dem zweiten Abstimmkontakt 51 angelegte Stromstärke der effektive Brechungsindex des erfindungsgemäßen Halbleiterlasers und damit die Wellenlänge dieses Lasers verändern.

Die erfindungsgemäße Abstimmvorrichtung kann bei Lasern verschiedener Halbleitermaterialien bzw. Halbleitermaterialsysteme angebracht werden. Der Laser kann zur Erzielung einmodiger Emissionen zusätzlich ein DFB-Gitter ober- oder unterhalb des laseraktiven Streifens besitzen. Der durch die Abstimmschicht 7 gegebene Abstimmbereich soll relativ nah (weniger als 200 nm) an der aktiven Schicht 2 sein, damit die Feldstärke des Lichtes in der Abstimmschicht 7 noch relativ groß ist und damit der Anteil des beeinflußten Lichts. Aus dem gleichen Grunde sollte die Diode des Abstimmbereichs nicht zu dünn sein (Dicke der Abstimmschicht 7 mindestens 50 nm). Eine zu große Dicke dieser Abstimmschicht 7 erfordert andererseits zu große Abstimmströme für die notwendige Ladungsträgerdichte. Die seitlich aufgewachsenen Seitenbereichsschichten 40, 41 müssen so dünn sein, daß der Abstand der Oberflächen neben dem Steg von der aktiven Laserschicht klein genug bleibt (Dicke von erster bzw. zweiter Seitenbereichsschicht 40, 41 und Zwischenschicht 3 zusammen nicht größer als ca. 200 nm), um den nötigen Unterschied im Brechungsindex zum Stegbereich und damit die notwendige Indexführung des Stegwellenleiters zu gewährleisten.

## Patentansprüche

1. Halbleiterlaser mit MCRW-ähnlider Struktur auf einem Substrat aus III-V-Halbleitermaterial mit einer aktiven Schicht, einem Steg, einem Substratkontakt und einem Stegkontakt,
**dadurch gekennzeichnet,**
- daß auf das Substrat (1) übereinander die aktive Schicht (2), eine Zwischenschicht (3), eine von einer ersten Seitenbereichsschicht (40) und von einer zweiten Seitenbereichsschicht (41) flankierte streifenförmige Abstimmschicht (7), sowie über dieser Abstimmschicht (7) übereinander eine streifenförmige Deckschicht (8) und eine Kontaktschicht (9) aufgewachsen sind,
- daß der Substratkontakt (10) auf der der überwachsenen Seite des Substrates (1) gegenüberliegenden Seite und der Stegkontakt (11) auf der Kontaktschicht (9) aufgebracht sind,
- daß die erste Seitenbereichsschicht (40) mit einem ersten Abstimmkontakt (50) versehen ist und
- daß die zweite Seitenbereichsschicht (41) mit einem zweiten Abstimmkontakt (51) versehen ist.

2. Halbleiterlaser nach Anspruch 1,
**dadurch gekennzeichnet,**
daß eine erste Passivierungsschicht (60) auf den Bereich der Halbleiteroberfläche zwischen dem ersten Abstimmkontakt (50) und dem Stegkontakt (11) und eine zweite Passivierungsschicht (61) auf dem Bereich der Oberfläche des Halbleitermateriales zwischen dem zweiten Abstimmkontakt (51) und dem Stegkontakt (11) aufgebracht sind.

3. Halbleiterlaser nach Anspruch 1 oder 2,
**dadurch gekennzeichnet,**
daß das Substrat (1), die erste Seitenbereichsschicht (40) und die zweite Seitenbereichsschicht (41) n-leitend dotiert sind, daß die Zwischenschicht (3), die Abstimmschicht (7) und die Deckschicht (8) p-leitend dotiert sind und
daß die Kontaktschicht (9) für niederohmigen Übergang zum Stegkontakt (11) ausreichend hoch p-leitend dotiert ist.

4. Halbleiterlaser nach Anspruch 1 oder 2,
**dadurch gekennzeichnet,**
daß das Substrat (1), die erste Seitenbereichsschicht (40) und die zweite Seitenbereichsschicht (41) p-leitend dotiert sind,
daß die Zwischenschicht (3), die Abstimmschicht (7) und die Deckschicht (8) n-leitend dotiert sind und
daß die Kontaktschicht (9) für niederohmigen Übergang zum Stegkontakt (11) ausreichend hoch n-leitend dotiert ist.

5. Halbleiterlaser nach einem der Ansprüche 1 bis 4,
**dadurch gekennzeichnet,**
daß das Substrat (1), die Zwischenschicht (3), die erste Seitenbereichsschicht (40), die zweite Seitenbereichsschicht (41) und die Deckschicht (8) InP sind,
daß die aktive Schicht (2) und die Abstimmschicht (7) InGaAsP sind und
daß die Kontaktschicht (9) InGaAs ist.

6. Halbleiterlaser nach einem der Ansprüche 1 bis 4,
**dadurch gekennzeichnet,**
daß die aktive Schicht (2) und die Abstimmschicht (7) quaternäres Halbleitermaterial sind.

## Claims

1. Semiconductor laser having MCRW-like structure on a substrate made of III-V semiconductor material, comprising an active layer, a ridge, a substrate contact and a ridge contact, characterised
- in that the active layer (2), an interlayer (3), and a strip-type tuning layer (7) flanked by a first lateral region layer (40) and by a second lateral region layer (41) are grown one on top of the other on the substrate (1), and a strip-type covering layer (8) and a contact layer (9) are grown one on top of the other on top of said tuning layer (7),
- in that the substrate contact (10) is applied to the side opposite the grown-over side of the substrate (1) and the ridge contact (11) is applied to the contact layer (9),
- in that the first lateral region layer (40) is provided with a first tuning contact (50), and
- in that the second lateral region layer (41) is provided with a second tuning contact (51).

2. Semiconductor laser according to Claim 1, characterised in that a first passivation layer (60) is applied to the region of the semiconductor surface between the first tuning contact (50) and the ridge contact (11) and a second passivation layer (61) is applied to the region of the surface of the semiconductor material between the second tuning contact (51) and the ridge contact (11).

3. Semiconductor laser according to Claim 1 or 2, characterised in that the substrate (1), the first lateral region layer (40) and the second lateral region layer (41) have n-type doping, in that the interlayer (3), the tuning layer (7) and the covering layer (8) have p-type doping, and in that the contact layer (9) has sufficiently heavy p-type doping to produce a low-impedance junction with the ridge contact (11).

4. Semiconductor laser according to Claim 1 or 2, characterised in that the substrate (1), the first lateral region layer (40) and the second lateral region layer (41) have p-type doping, in that the interlayer (3), the tuning layer (7) and the covering layer (8) have n-type doping, and in that the contact layer (9) has sufficiently heavy n-type doping to produce a low-impedance junction with the ridge contact (11).

5. Semiconductor laser according to one of Claims 1 to 4, characterised in that the substrate (1), the interlayer (3), the first lateral region layer (4), the second lateral region layer (41) and the covering layer (8) are InP, in that the active layer (2) and the tuning layer (7) are InGaAsP, and in that the contact layer (9) is InGaAs.

6. Semiconductor laser according to one of Claims 1 to 4, characterised in that the active layer (2) and the tuning layer (7) are quaternary semiconductor material.

## Revendications

1. Laser à semiconducteurs comportant une structure de type MCRW sur un substrat formé d'un matériau semiconducteur (III-V), comportant une couche active, une barrette, un contact de substrat et un contact de barrette,
caractérisé par le fait
- que sur le substrat (1) on fait croître en superposition la couche active (2), une couche intermédiaire (3), une couche de réglage d'accord en forme de bande (7), qui est flanquée d'une première couche de région latérale (40) et d'une seconde couche de région latérale (41), ainsi qu'au-dessus de cette couche de réglage d'accord (7), et en superposition, une couche de revêtement (8) en forme de bande et un couche de contact (9),
- que le contact de substrat (10) est disposé sur la face, située à l'opposé de la face du substrat (1) recouverte par croissance, et le contact de barrette est déposé sur la couche de contact (9),
- que la première couche de région latérale (40) est pourvue d'un premier contact de réglage d'accord (50), et
- que la seconde couche de région latérale (41) est pourvue d'un second contact de réglage d'accord (51).

2. Laser à semiconducteurs suivant la revendication 1, caractérisé par le fait qu'une première couche de passivation (60) est disposée sur la région de la surface semiconductrice située entre le premier contact de réglage d'accord (50) et le contact de barrette (11), et qu'une seconde couche de passivation (61) est déposée sur la région de la surface du matériau semiconducteur située entre le second contact de réglage d'accord (50) et le contact de barrette (11).

3. Laser à semiconducteurs selon la revendication 1 ou 2, caractérisé par le fait
que le substrat (1), la première couche de région latérale (40) et la seconde couche de région latérale (41) sont dopés de manière à être conducteurs de type n,
que la couche intermédiaire (3), la couche de réglage d'accord (7) et la couche de revêtement (8) sont dopées de manière à être conductrices du type p, et
que la couche de contact (9) pour la jonction de faible valeur ohmique avec le contact de barrette (11) est dopée de manière à présenter une conduction suffisamment élevée de type p.

4. Laser à semiconducteurs selon la revendication 1 ou 2, caractérisé par le fait
que le substrat (1), la première couche de région latérale (40) et la seconde couche de région latérale (41) sont dopés de manière à être conducteurs de type p,
que la couche intermédiaire (3), la couche de réglage d'accord (7) et la couche de revêtement (8) sont dopées de manière à être conductrices de type n, et
que la couche de contact (9) pour la jonction de faible valeur ohmique avec le contact de barrette (11) est dopée de manière à présenter une conduction suffisamment élevée de type n.

5. Laser à semiconducteurs selon l'une des revendications 1 à 4, caractérisé par le fait
que le substrat (1), la couche intermédiaire (3), la première couche de région latérale (40), la seconde couche de région latérale (41) et la couche de revêtement (8) sont formées de InP,
que la couche active (2) et la couche de réglage d'accord (7) sont formée de InGaAsP, et
que la couche de contact (9) est formée de InGaAs.

6. Laser à semiconducteurs selon l'une des revendications 1 à 4, caractérisé par le fait que la couche active (2) et la couche de réglage d'accord (7) sont formées d'un matériau semiconducteur quaternaire.
